# EUROPEAN PATENT APPLICATION

(11) **EP 3 416 189 A1**
(43) Date of publication of application: **19.12.2018**
(21) Application number: 17750138.4
(22) Date of filing: 01.02.2017
(51) Int. Cl.: H01L 25/07, H01L 23/48, H01L 25/065, H01L 25/18, H02M 7/48

(54) **SEMICONDUCTOR MODULE AND INVERTER DEVICE**

(30) Priority: 12.02.2016 JP 2016024694
(71) Applicant: Kabushiki Kaisha Toyota Jidoshokki, Kariya-shi, Aichi-ken 448-8671 (JP)
(72) Inventor: KATO, Naoki, Kariya-shi Aichi 448-8671 (JP); MORI, Shogo, Kariya-shi Aichi 448-8671 (JP)
(74) Representative: TBK
(86) International application number: PCT/JP2017/003572
(87) International publication number: WO 2017/138414

(57) **Abstract**

This semiconductor module is provided with a first conductive plate, a first switching element mounted on the first conductive plate, a second conductive plate provided on the first switching element, a second switching element laminated on the second conductive plate, a third conductive plate provided on the second switching element, and first and second control terminals. Each of the switching elements is configured using silicon carbide. On a second lower conductive plate surface of the second conductive plate, a protruding part is provided that protrudes from said second lower conductive plate surface toward a first element upper surface and that is bonded to a first upper electrode.

## Description

### TECHNICAL FIELD

The present invention relates to a semiconductor module and an inverter device.

### BACKGROUND ART

Patent document 1 describes an example of a known semiconductor module including a plurality of switching elements in which a second switching element is laminated on a first switching element with a bus bar located in between. The bus bar includes a two-dimensionally constricted region that is not connected to the two switching elements, and a gate pad exists in the constricted region. The gate pad is electrically connected to a wire. Patent document further describes that silicon carbide (SiC) is used as the switching elements.

### PRIOR ART DOCUMENTS

### PATENT DOCUMENT

Patent Document 1: Japanese Laid-Open Patent Publication No. 2004-140068

### SUMMARY OF THE PRESENT INVENTION

### PROBLEMS THAT ARE TO BE SOLVED BY THE PRESENT INVENTION

Here, the inventors of the present invention have found that in the semiconductor module including the laminated first and second switching elements, heat dissipation decreases when the bus bar includes the constricted region. This may lower the heat resistance of the semiconductor module. In detail, for example, in a configuration in which the second switching element is laminated on the first switching element that has a first element upper surface on which a gate electrode is formed, when the bus bar includes the constricted region to expose the gate electrode of the first switching element, the bus bar does not cover part of a lower surface of the second switching element, or the second element lower surface. In the portion that is not covered with the bus bar, heat is not transferred to the bus bar. This hinders heat dissipation. Therefore, heat may accumulate in the constricted region and lower the heat resistance of the semiconductor module.

It is an object of the present invention to provide a semiconductor module and an inverter device that increase heat dissipation in a configuration in which switching elements are laminated.

### MEANS FOR SOLVING THE PROBLEM

A semiconductor module that solves the above problem includes a first conductive plate, a first switching element that is placed on the first conductive plate and formed from silicon carbide, a second conductive plate arranged on the first switching element, a second switching element laminated on the second conductive plate and formed from silicon carbide, a third conductive plate arranged on the second switching element, and first and second control terminals. The first switching element includes a first element upper surface, on which a first upper electrode and a first gate electrode with which the first control terminal is joined are formed, and a first element lower surface located at a side opposite to the first element upper surface and on which a first lower electrode joined with the first conductive plate is formed. The second switching element includes a second element upper surface, on which a second upper electrode joined with the third conductive plate and a second gate electrode with which the second control terminal is joined are formed, and a second element lower surface located at a side opposite to the second element upper surface. A second lower electrode is formed on the second element lower surface. The second conductive plate includes a second upper conductive plate surface, on which the second switching element is placed and which is joined with the second lower electrode and covers the entire second element lower surface, and a second lower conductive plate surface, located at a side opposite to the second upper conductive plate surface and facing the first element upper surface. The second lower conductive plate surface includes a projection projecting from the second lower conductive plate surface toward the first element upper surface and joined with the first upper electrode. The projection is located at a position that does not overlap the first gate electrode as viewed in a lamination direction of the first and second switching elements. Part of the first control terminal is located between the first gate electrode and the second lower conductive plate surface.

An inverter device that solves the above problem includes the semiconductor module and is configured to drive an electric motor that is arranged in a motor-driven compressor for a vehicle. The inverter device includes a transformer that transforms DC power and an LC filter circuit to which the DC power transformed by the transformer is input. The semiconductor module is configured to convert the DC power output from the LC filter circuit into drive power that allows the electric motor to be driven.

A semiconductor module that solves the above problem includes a first conductive plate, a switching element that is placed on the first conductive plate and formed from silicon carbide, a second conductive plate arranged on the switching element, an SiC element that is laminated on the second conductive plate and formed from silicon carbide, and a control terminal. The switching element includes a first element upper surface, on which a first upper electrode and a gate electrode with which the control terminal is joined are formed, and a first element lower surface, located at a side opposite to the first element upper surface and on which a first lower electrode joined with the first conductive plate is formed. The SiC element includes a second element upper surface, on which a second upper electrode is formed, and a second element lower surface, located at a side opposite to the second element upper surface. A second lower electrode is formed on the second element lower surface. The second conductive plate includes a second upper conductive plate surface, on which the SiC element is placed and which is joined with the second lower electrode and covers the entire second element lower surface, and a second lower conductive plate surface, located at a side opposite to the second upper conductive plate surface and facing the first element upper surface. The second lower conductive plate surface includes a projection projecting from the second lower conductive plate surface toward the first element upper surface and joined with the first upper electrode. The projection is located at a position that does not overlap the gate electrode as viewed from a lamination direction of the switching element and the SiC element. Part of the control terminal is located between the gate electrode and the second lower conductive plate surface.

### BRIEF DESCRIPTION OF DRAWINGS

Fig. 1 is a partially cutaway schematic cross-sectional view showing an inverter module, an inverter device, a motor-driven compressor, and a vehicle air conditioner.
Fig. 2 is a circuit diagram illustrating the electric configuration of the motor-driven compressor in Fig. 1.
Fig. 3 is a cross-sectional view taken along line 3-3 in Fig. 1.
Fig. 4 is a front view of the inverter module shown in Fig. 1.
Fig. 5 is an exploded perspective view of the inverter module shown in Fig. 4.
Fig. 6 is an exploded perspective view of the inverter module shown in Fig. 4.
Fig. 7 is a cross-sectional view taken along line 7-7 in Fig. 4.
Fig. 8 is a cross-sectional view taken along line 8-8 in Fig. 4.
Fig. 9 is a schematic cross-sectional view illustrating an inverter module of another example.

### EMBODIMENTS OF THE INVENTION

One embodiment of a semiconductor module, an inverter device including the semiconductor module, and a motor-driven compressor including the inverter device will now be described. The motor-driven compressor of the present embodiment is installed in a vehicle and used in a vehicle air conditioner.

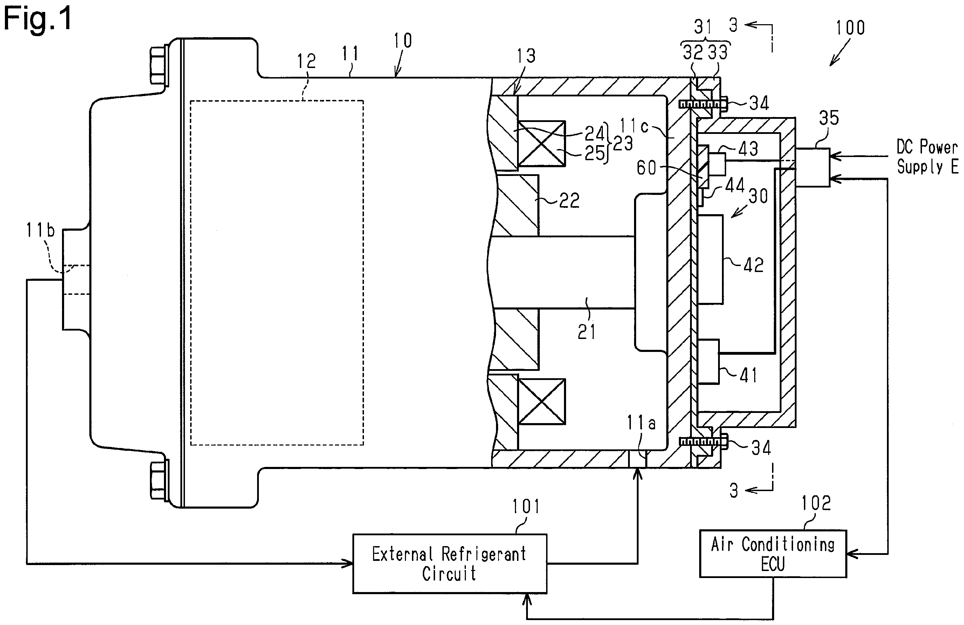

As illustrated in Fig. 1, a vehicle air conditioner 100 includes a motor-driven compressor 10, and an external refrigerant circuit 101 that supplies refrigerant serving as a fluid to the motor-driven compressor 10. For example, the external refrigerant circuit 101 includes a heat exchanger, an expansion valve, and the like. In the vehicle air conditioner 100, the motor-driven compressor 10 compresses the refrigerant and the external refrigerant circuit 101 exchanges heat with and expands the refrigerant to heat and cool that passenger compartment.

The vehicle air conditioner 100 includes an air conditioning ECU 102 that entirely controls the vehicle air conditioner 100. The air conditioning ECU 102 is configured to recognize the passenger compartment temperature, a set temperature (target temperature) set by a user. Based on these parameters, the air conditioning ECU 102 transmits various commands, such as ON/OFF commands, to the motor-driven compressor 10.

The motor-driven compressor 10 includes a housing 11, a compression unit 12, and an electric motor 13. The housing 11 includes a suction port 11a through which a refrigerant is drawn from the external refrigerant circuit 101. The compression unit 12 and the electric motor 13 are accommodated in the housing 11.

The housing 11 is substantially cylindrical as a whole and formed from a heat conductive material (for example, a metal such as aluminum). The housing 11 includes discharge port 11b through which the refrigerant is discharged.

When a rotation shaft 21, which will be described later rotates, the compression unit 12 compresses the refrigerant drawn through the suction port 11a into the housing 11 and discharges the compressed refrigerant from the discharge port 11b. Furthermore, the specific configuration of the compression unit 12 may be of any type, such as a scroll type, a piston type, or a vane type.

The electric motor 13 drives the compression unit 12. The electric motor 13 includes, for example, the rod-shaped rotation shaft 21 that is supported in a rotatable manner by the housing 11, a cylindrical rotor 22 that is fixed to the rotation shaft 21, and a stator 23 that is fixed to the housing 11. An axial direction of the rotation shaft 21 coincides with an axial direction of the cylindrical housing 11. The stator 23 includes a cylindrical stator core 24 and coils 25 that are wound around teeth of the stator core 24. The rotor 22 is opposed to the stator 23 in a radial direction of the rotation shaft 21. When the coils 25 are energized, the rotor 22 and the rotation shaft 21 rotate, and the compression unit 12 compresses the refrigerant.

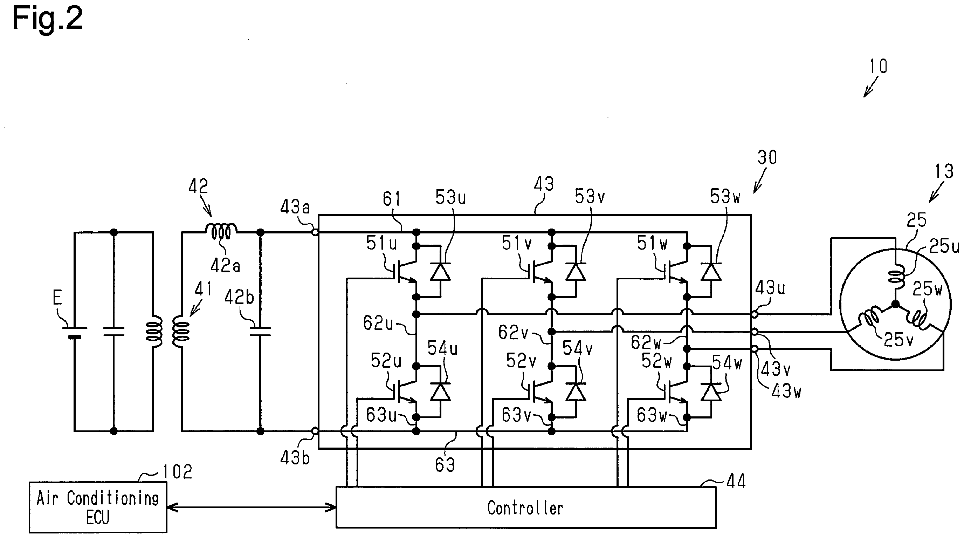

As illustrated in Fig. 2, the coils 25 have a three-phase construction that includes a U-phase coil 25u, a V-phase coil 25v, and a W-phase coil 25w. For example, the coils 25u to 25w form a Y-connection.

As illustrated in Fig. 1, the motor-driven compressor 10 includes an inverter device 30 that drives the electric motor 13, and an inverter case 31 in which the inverter device 30 is accommodated.

The inverter case 31 is formed from a heat conductive material (for example, a metal such as aluminum). The inverter case 31 includes a plate-shaped base member 32 and a tubular cover member 33. Among the two axial walls of the housing 11, the inverter case 31 is in contact with the wall 11c located at the side opposite to the discharge port 11b. The cover member 33 is coupled to the base member 32. The base member 32 and the cover member 33 are fixed to the housing 11 by bolt 34 serving as fasteners. Thus, the inverter case 31 and the inverter device 30, which is accommodated in the inverter case 31, are coupled to the housing 11. That is, the inverter device 30 of the present embodiment is integrated with the motor-driven compressor 10.

The inverter case 31 and the housing 11 are in contact and thus thermally coupled to each other. In addition, the inverter device 30 is thermally coupled to the housing 11 through the inverter case 31.

A connector 35 is provided on the inverter case 31 (specifically, the cover member 33). The connector 35 supplies the inverter device 30 with DC power from a DC power supply E, which is installed in a vehicle, and electrically connects the air conditioning ECU 102 and the inverter device 30. The DC power supply E is, for example, an electricity storage device such as a rechargeable battery or an electric double-layer capacitor that are installed in the vehicle.

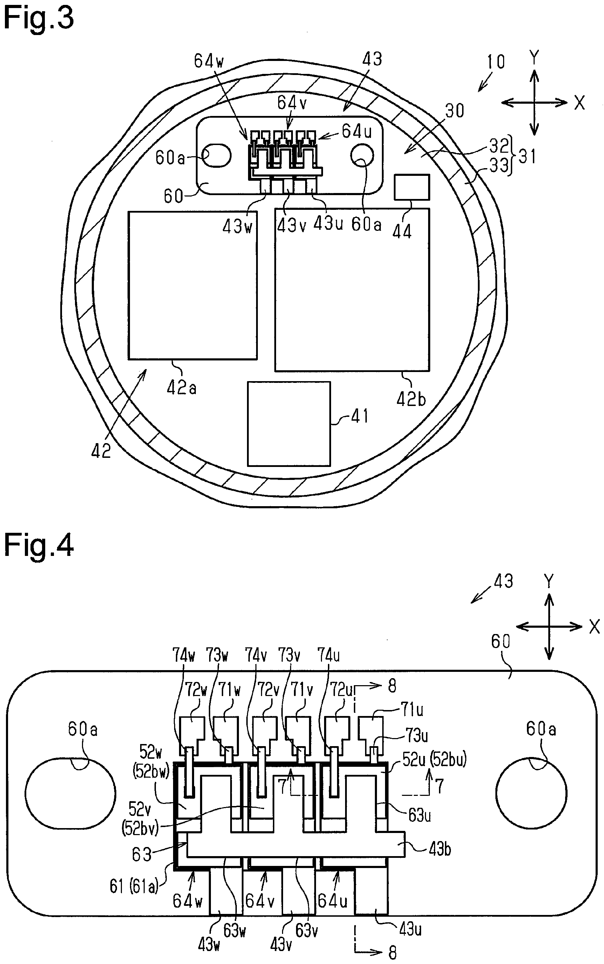

As illustrated in Fig. 2 and Fig. 3, the inverter device 30 includes a transformer 41 and a filter circuit 42. The transformer 41 transforms the DC power supplied from the DC power supply E. The DC power transformed by the transformer 41 is input to the filter circuit 42. In addition, the inverter device 30 includes an inverter module 43 and a controller 44. The inverter module 43 converts the DC power output from the filter circuit 42 into AC power that can drive the electric motor 13 as a semiconductor module. The controller 44 that controls the inverter module 43. The inverter module 43 is electrically connected to the coils 25 of the electric motor 13 by hermetic terminals (not illustrated) extending through both of the wall 11c of the housing 11 and the base member 32.

The electric configuration of the inverter device 30 will now be described.

As illustrated in Fig. 2, in the transformer 41, a primary coil is connected to the DC power supply E, and a secondary coil is connected to the filter circuit 42. A transformation ratio of the transformer 41 is set in correspondence with the voltage at the DC power supply E so that the voltage of DC power output from the transformer 41 is a value suitable for driving the electric motor 13.

The filter circuit 42 is an LC filter circuit configured by a filter coil 42a and a filter capacitor 42b. The filter circuit 42 is a low-pass filter circuit that reduces noise at frequencies higher than a threshold frequency (for example, a cut-off frequency) that is determined in advance. The filter circuit 42 reduces high-frequency noise of the DC power output from the transformer 41 and transfers the DC power. The filter circuit 42 also restricts the emission of high-frequency noise, which is generated from the inverter module 43, to the outside of the inverter device 30.

In addition, the cut-off frequency of the filter circuit 42 is based on the inductance of the filter coil 42a and the capacitance of the filter capacitor 42b. Furthermore, the filter capacitor 42b of the present embodiment is a film capacitor. However, the filter capacitor 42b is not limited to a film capacitor and may be an electrolytic capacitor or the like.

The inverter module 43 includes two input terminals 43a and 43b and three output terminals 43u to 43w. Both of the input terminals 43a and 43b are electrically connected to the filter circuit 42. The three output terminals 43u to 43w are electrically connected to the electric motor 13.

The inverter module 43 includes U-phase switching elements 51u and 52u corresponding to the U-phase coil 25u, V-phase switching elements 51v and 52v corresponding to the V-phase coil 25v, and W-phase switching elements 51w and 52w corresponding to the W-phase coil 25w.

For example, the switching elements 51u to 52w are power switching elements such as IGBTs. The switching elements 51u to 52w are constructed by using silicon carbide (SiC). For example, the switching elements 51u to 52w are configured by a silicon carbide substrate including a drift region and a body region.

The U-phase switching elements 51u and 52u are connected to each other in series by a connection line, and the connection line is connected to the U-phase coil 25u via the U-phase output terminal 43u. In addition, DC power from the filter circuit 42 is input to a series-connected body of the U-phase switching elements 51u and 52u. Specifically, the collector of the U-phase upper arm switching element 51u is connected to the first input terminal 43a. The emitter of the U-phase lower arm switching element 52u is connected to the second input terminal 43b.

Furthermore, the other switching elements 51v, 52v, 51w, and 52w are connected in the same manner as the U-phase switching elements 51u and 52u except in that the corresponding output terminals and coil are different. Thus, such connection will not be described.

As illustrated in Fig. 2, the inverter module 43 includes freewheeling diodes 53u to 54w (body diodes) which are connected in inverse-parallel to the switching elements 51u to 52w. Specifically, the anodes of the freewheeling diodes 53u to 54w are respectively connected to the emitters of the switching elements 51u to 52w, and the cathodes of the freewheeling diodes 53u to 54w are respectively connected to the collectors of the switching elements 51u to 52w.

Furthermore, to simplify the description, the switching elements 51u, 51v, and 51w of the upper arm will hereafter simply referred to as upper arm switching elements 51u to 51w, and the switching elements 52u, 52v, and 52w of the lower arm will hereafter simply be referred to as the lower arm switching elements 52u to 52w. In the same manner, the freewheeling diodes 53u, 53v, and 53w, which are connected in inverse-parallel, to the upper arm switching elements 51u to 51w will hereafter simply be referred to as the upper arm freewheeling diodes 53u to 53w, and the freewheeling diodes 54u, 54v, and 54w, which are connected in inverse-parallel, to the lower arm switching elements 52u to 52w, will simply be referred to as the lower arm freewheeling diodes 54u to 54w.

In the present embodiment, the upper arm switching elements 51u to 51w each correspond to "a first switching element," and the lower arm switching elements 52u to 52w correspond to "a second switching element."

The controller 44 is connected to the gates of the switching elements 51u to 52w and controls switching operations of the switching elements 51u to 52w. The controller 44 is electrically connected to the air conditioning ECU 102 via the connector 35 and cyclically turns the switching elements 51u to 52w on and off based on commands from the air conditioning ECU 102. For example, the controller 44 performs pulse width modulation (PWM) control on the inverter module 43. However, the specific control mode of the controller 44 is not limited to PWM control, and any control may be performed instead.

As illustrated in Fig. 3, the transformer 41, the filter coil 42a, the filter capacitor 42b, and the inverter module 43 are attached to the base member 32 of the inverter case 31. The base member 32 has a circular shape as viewed in an axial direction of the rotation shaft 21. The filter coil 42a and the filter capacitor 42b are arranged next to each other in one direction near the center of the base member 32. The inverter module 43 and the transformer 41 are arranged at the two sides of the base member 32 in a direction perpendicular to the layout direction of the filter coil 42a and the filter capacitor 42b. In other words, the inverter module 43 is located at the side of the filter coil 42a and the filter capacitor 42b opposite to the transformer 41. Furthermore, in the present embodiment, the controller 44 is provided separately from the inverter module 43 but instead may be incorporated in the inverter module 43.

The structure of the inverter module 43 will now be described.

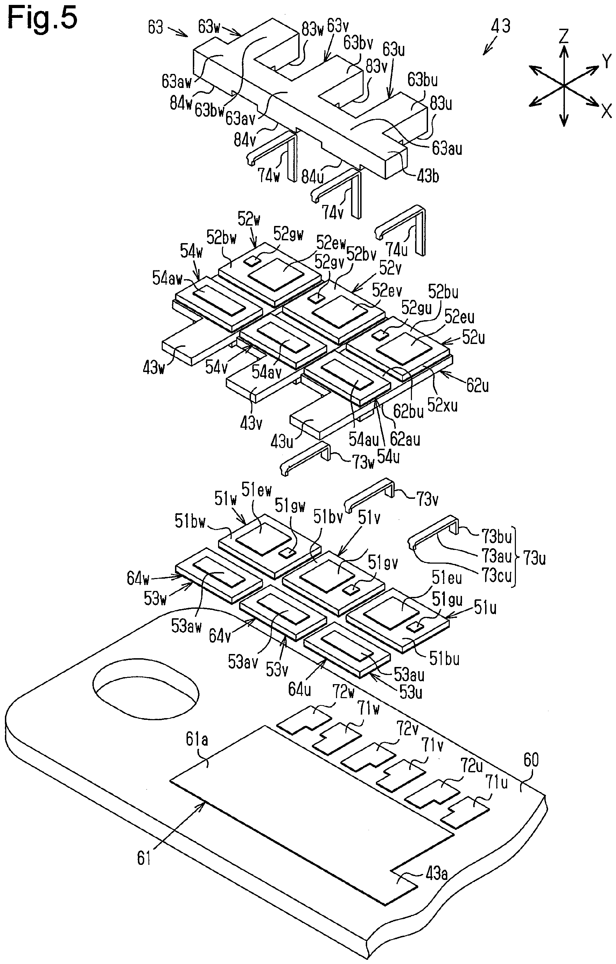

As illustrated in Figs. 4 and 5, the inverter module 43 includes an insulation substrate 60 and a first conductive plate 61 that is mounted on the insulation substrate 60. The upper arm switching elements 51u to 51w and the upper arm freewheeling diodes 53u to 53w are placed on the first conductive plate 61.

The inverter module 43 includes second conductive plates 62u to 62w which are provided on the upper arm switching elements 51u to 51w and the upper arm freewheeling diodes 53u to 53w. The lower arm switching elements 52u to 52w are laminated on the upper arm switching elements 51u to 51w with the second conductive plates 62u to 62w located in between. The lower arm freewheeling diodes 54u to 54w are laminated on the upper arm freewheeling diodes 53u to 53w with the second conductive plates 62u to 62w located in between. In addition, the inverter module 43 includes a third conductive plate 63 that is provided on the lower arm switching elements 52u to 52w and the lower arm freewheeling diodes 54u to 54w.

The inverter module 43 has a structure in which the order of lamination from the insulation substrate 60 is the first conductive plate 61, the upper arm switching elements 51u to 51w and the upper arm freewheeling diodes 53u to 53w, the second conductive plates 62u to 62w, the lower arm switching elements 52u to 52w and the lower arm freewheeling diodes 54u to 54w, and the third conductive plate 63.

Here, a unit including both of the U-phase switching elements 51u and 52u, both of the U-phase freewheeling diodes 53u and 54u, the U-phase second conductive plate 62u, and the like is set as a U-phase unit 64u. In the same manner, a unit including both of the V-phase switching elements 51v and 52v, both of the V-phase freewheeling diodes 53v and 54v, the V-phase second conductive plate 62v, and the like is set as a V-phase unit 64v, and a unit including both of the W-phase switching elements 51w and 52w, both of the W-phase freewheeling diodes 53w and 54w, the W-phase second conductive plate 62w is set as a W-phase unit 64w. The units 64u to 64w have the same construction.

In addition to the first conductive plate 61, the insulation substrate 60 includes a plurality of control pads 71u to 72w that electrically connect the switching elements 51u to 52w and the controller 44. The inverter module 43 includes control terminals 73u to 74w that electrically connect the switching elements 51u to 52w and the control pads 71u to 72w. Specifically, the U-phase unit 64u includes the U-phase upper arm control terminal 73u, which electrically connects the U-phase upper arm switching element 51u and the U-phase upper arm control pad 71u, and the U-phase lower arm control terminal 74u, which electrically connects the U-phase lower arm switching element 52u and the U-phase lower arm control pad 72u. The V-phase unit 64v includes a V-phase upper arm control terminal 73v, which electrically connects the V-phase upper arm switching element 51v and a V-phase upper arm control pad 71v, and a V-phase lower arm control terminal 74v, which electrically connects the V-phase lower arm switching element 52v and a V-phase lower arm control pad 72v. The W-phase unit 64w includes a W-phase upper arm control terminal 73w, which electrically connects the W-phase upper arm switching element 51w and a W-phase upper arm control pad 71w, and a W-phase lower arm control terminal 74w, which electrically connects the W-phase lower arm switching element 52w and a W-phase lower arm control pad 72w. The upper arm control terminals 73u to 73w each correspond to "a first control terminal" and the lower arm control terminals 74u to 74w each correspond to "a second control terminal."

Each element of the inverter module 43 will now be described in detail.

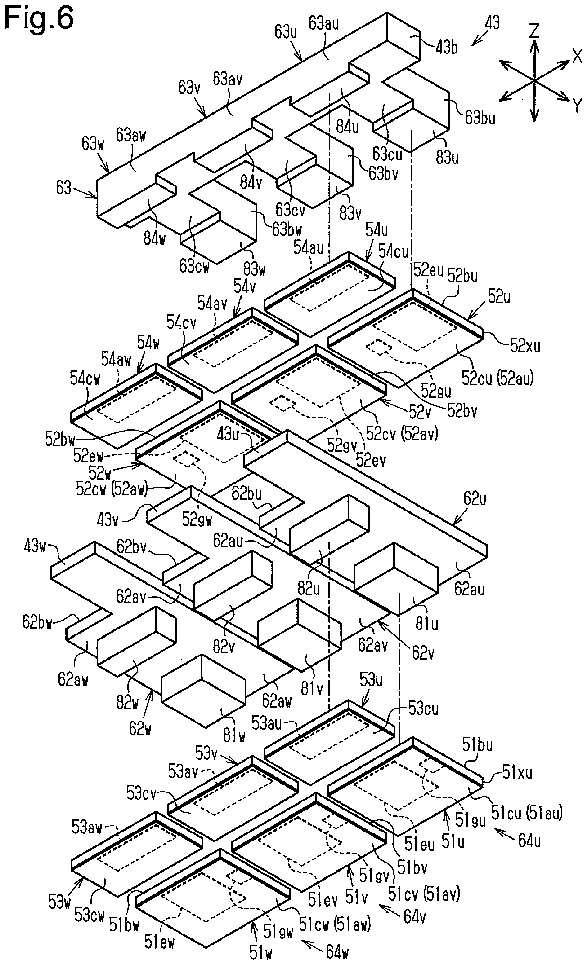

As illustrated in Figs. 5 and 6, the switching elements 51u to 52w each have a generally rectangular parallelepiped form as a whole. The switching elements 51u to 52w include element lower surfaces 51au to 52aw and element upper surfaces 51bu to 52bw. As illustrated in Fig. 6, collector electrodes 51cu and 52cw are formed on the element lower surfaces 51au to 52aw. The collector electrodes 51cu to 52cw are formed entirely by the element lower surfaces 51au to 52aw.

As illustrated in Fig. 5, emitter electrodes 51eu to 52ew and gate electrodes 51gu to 52gw are formed on the element upper surfaces 51bu to 52bw of the switching elements 51u to 52w. The emitter electrodes 51eu to 52ew are formed to be larger than the gate electrodes 51gu to 52gw. Each of the emitter electrodes 51eu to 52ew and each of the gate electrodes 51gu to 52gw are spaced apart from each other in an X direction on the element upper surfaces 51bu to 52bw. Furthermore, an insulation layer is formed at portion other than the emitter electrodes 51eu to 52ew and the gate electrodes 51gu and 52gw on the element upper surfaces 51bu to 52bw.

The upper arm emitter electrodes 51eu to 51ew each correspond to "a first upper electrode," the upper arm gate electrodes 51gu to 51gw each correspond to "a first gate electrode," and the upper arm element upper surfaces 51bu to 51bw each correspond to "a first element upper surface." In addition, the upper arm collector electrodes 51cu to 51cw each correspond to "a first lower electrode," and the upper arm element lower surfaces 51au to 51aw each correspond to "a first element lower surface."

In addition, the lower arm emitter electrodes 52eu to 52ew each correspond to "a second upper electrode," the lower arm gate electrodes 52gu to 52gw each correspond to "a second gate electrode," and the lower arm element upper surfaces 52bu to 52bw each correspond to "a second element upper surface." In addition, the lower arm collector electrodes 52cu to 52cw each correspond to "a second lower electrode," and the lower arm element lower surfaces 52au to 52aw each correspond to "second element lower surface."

The freewheeling diodes 53u to 54w each have a generally rectangular parallelepiped form as a whole. The freewheeling diodes 53u to 54w include a diode lower surface on which cathode electrodes 53cu to 54cw are formed, and a diode upper surface on which anode electrodes 53au to 54aw are formed. The cathode electrodes 53cu to 54cw are formed entirely by the diode lower surface. The anode electrodes 53au to 54aw are formed to be slightly smaller than the diode upper surface. Furthermore, an insulation layer is formed at portions other than the anode electrodes 53au to 54aw in the diode upper surface.

As illustrated in Fig. 5, the insulation substrate 60 has a rectangular plate shape with rounded corners. Coupling holes 60a are formed in the two longitudinal ends of the insulation substrate 60. Fasteners such as screws are inserted through the coupling holes 60a and engaged with the base member 32 to fix the insulation substrate 60 to the base member 32 in a state in which a thickness direction of the insulation substrate 60 coincides with the axial direction of the rotation shaft 21. This fixes the inverter module 43 to the base member 32. In this case, the insulation substrate 60 can exchange heat with the refrigerant through the base member 32 and the housing 11.

To simplify description, the longitudinal direction of the insulation substrate 60 will hereafter be referred to as the X direction, and the transverse direction of the insulation substrate 60 will hereafter be referred to as the Y direction. In addition, the lamination direction of the upper arm switching elements 51u to 51w and the lower arm switching elements 52u to 52w will hereafter be referred to as the Z direction. In addition, in the Z direction, a direction from the insulation substrate 60 toward the third conductive plate 63 will hereafter be referred to as the upper direction, and a direction from the third conductive plate 63 toward the insulation substrate 60 will hereafter be referred to as the lower direction. The Z direction may also be referred to as the thickness direction of the insulation substrate 60.

The Z direction that is the lamination direction of the upper arm switching elements 51u to 51w and the lower arm switching elements 52u to 52w is not limited to the vertical direction or the horizontal direction and may be any direction such as a direction that intersects both of the vertical direction and the horizontal direction. In the present embodiment, the Z direction coincides with the axial direction of the rotation shaft 21. In the same manner, to simplify description, the upper direction and the lower direction are used to illustrate the positional relationship of the switching elements 51u to 52w and are not limited to the vertical direction (gravity direction).

As illustrated in Figs. 4 and 5, the first conductive plate 61 has a plate shape and extends in the X direction that is the layout direction of the units 64u to 64w. Further, the first conductive plate 61 is provided between the two coupling holes 60a of the insulation substrate 60. The first conductive plate 61 includes a first base portion 61a having a rectangular plate shape in which the X direction is the longitudinal direction, and a first input terminal 43a that projects from one longitudinal end surface of the first base portion 61a in the X direction. In addition, the control pads 71u to 72w are provided at positions spaced apart from the first conductive plate 61 in the Y direction and are spaced apart from one another in the X direction.

The units 64u to 64w are provided on the first conductive plate 61 in a state aligned in the X direction that is the longitudinal direction of the insulation substrate 60. Specifically, the upper arm switching elements 51u to 51w are spaced apart from one another by a predetermined gap and aligned in the X direction on the first conductive plate 61. The upper arm freewheeling diodes 53u to 53w are arranged on the first conductive plate 61 at positions spaced apart from the upper arm switching elements 51u to 51w in a direction (specifically, the Y direction) that is perpendicular to the layout direction of the upper arm switching elements 51u to 51w. In this case, in the same manner as the upper arm switching elements 51u to 51w, the upper arm freewheeling diodes 53u to 53w are spaced apart from one another by a predetermined gap and aligned in the X direction.

The upper arm collector electrodes 51cu to 51cw are joined with the first conductive plate 61 by a conductive joining material J such as solder or a silver paste. In addition, the upper arm cathode electrodes 53cu to 53cw are joined with the first conductive plate 61 by the joining material J. Consequently, the same phases in the upper arm collector electrodes 51cu to 51cw and the upper arm cathode electrodes 53cu to 53cw are electrically connected with one another, and the upper arm collector electrodes 51cu to 51cw are electrically connected to one another.

When describing the configuration of the U-phase unit 64u in detail, as illustrated in Figs. 5 and 6, the U-phase second conductive plate 62u of the U-phase unit 64u has a rectangular plate shape in which the Y direction that is the layout direction of the U-phase upper arm switching element 51u and the U-phase upper arm freewheeling diode 53u is set as the longitudinal direction. The U-phase second conductive plate 62u is sized to cover both of the U-phase upper arm switching element 51u and the U-phase upper arm freewheeling diode 53u from the upper side. The U-phase second conductive plate 62u includes a U-phase output terminal 43u projecting from one longitudinal end surface in a direction (specifically, the Y direction) that is perpendicular to the one longitudinal end surface.

The U-phase second conductive plate 62u includes a U-phase second lower conductive plate surface 62au and a U-phase second upper conductive plate surface 62bu. The U-phase second lower conductive plate surface 62au, which is a surface opposite to the U-phase second upper conductive plate surface 62bu, faces the U-phase upper arm element upper surface 51bu in the Z direction.

As illustrated in Figs. 6 to 8, a U-phase first projection 81u and a U-phase second projection 82u, which project from the U-phase second lower conductive plate surface 62au toward the U-phase upper arm element upper surface 51bu (specifically, toward a lower side), are provided on the U-phase second lower conductive plate surface 62au. In the present embodiment, both of the projections 81u and 82u are formed from the same material as the U-phase second conductive plate 62u and are formed integrally with the U-phase second conductive plate 62u. Accordingly, the projections 81u and 82u are electrically connected to the U-phase second conductive plate 62u. Both of the projections 81u and 82u on the U-phase second lower conductive plate surface 62au are set to have the same projecting dimension.

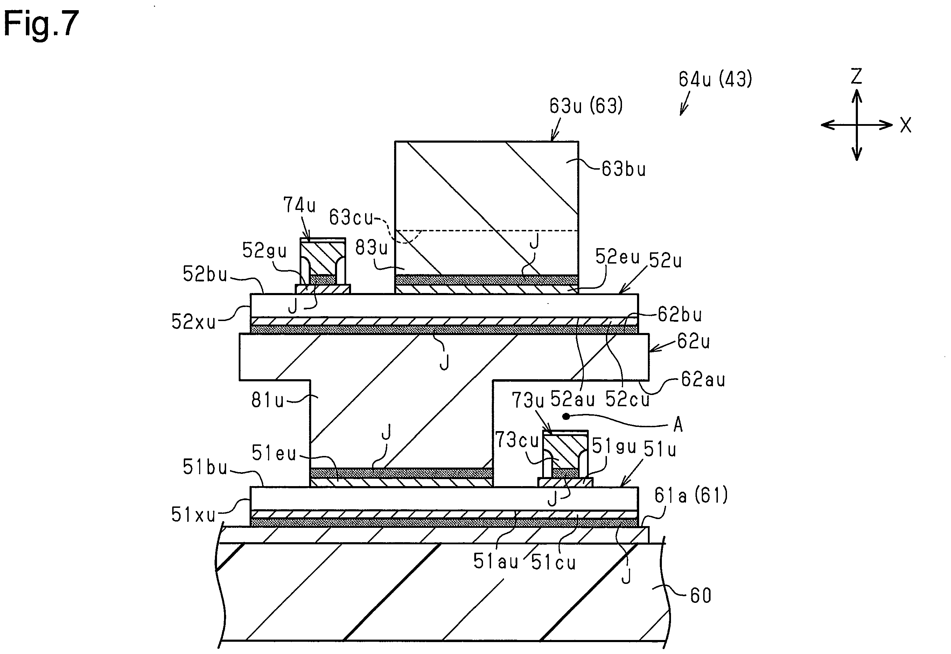

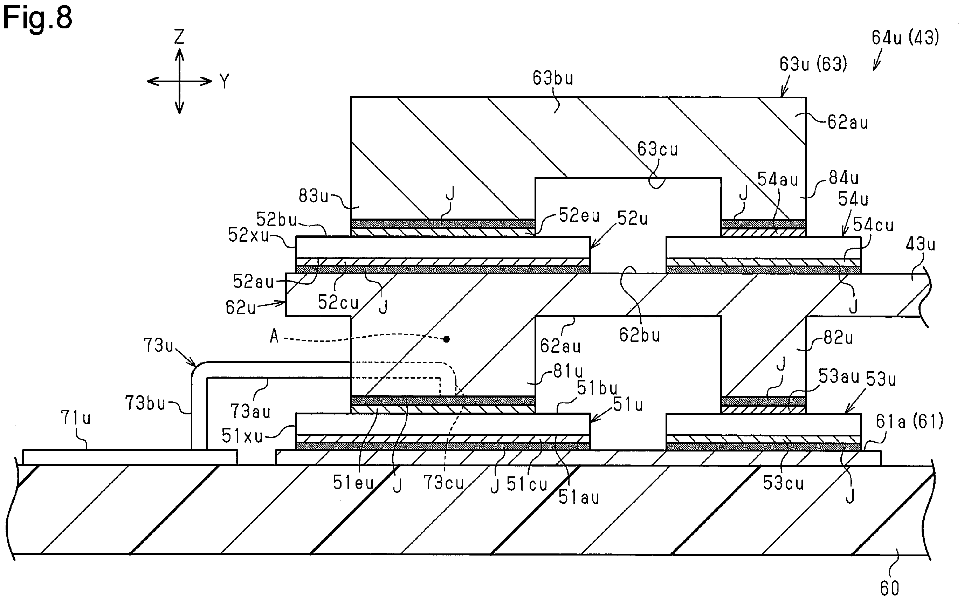

As illustrated in Figs. 6 and 7, the U-phase first projection 81u is provided at a position that does not overlap the U-phase upper arm gate electrode 51gu and overlaps the U-phase upper arm emitter electrode 51eu as viewed in the Z direction. The U-phase first projection 81u is shaped to be located in a projection range of the U-phase upper arm emitter electrode 51eu as viewed from the Z direction. Specifically, the U-phase first projection 81u has the same shape as the U-phase upper arm emitter electrode 51eu as viewed in the Z direction. As illustrated in Figs. 7 and 8, the U-phase first projection 81u is joined with the U-phase upper arm emitter electrode 51eu by the joining material J. In this case, the U-phase first projection 81u is in contact with the entire U-phase upper arm emitter electrode 51eu through the joining material J.

The U-phase second projection 82u is provided at a position that does not overlap the U-phase upper arm gate electrode 51gu and overlaps the U-phase upper arm anode electrode 53au as viewed in the Z direction. The U-phase second projection 82u is shaped to be located in a projection range of the U-phase upper arm anode electrode 53au as viewed in the Z direction. Specifically, the U-phase second projection 82u has the same shape as the U-phase upper arm anode electrode 53au as viewed in the Z direction. As illustrated in Fig. 8, the U-phase second projection 82u is joined with the U-phase upper arm anode electrode 53au through the joining material J. Thus, the U-phase upper arm anode electrode 53au and the U-phase upper arm emitter electrode 51eu are electrically connected to each other by the U-phase second conductive plate 62u. That is, the first conductive plate 61 and the U-phase second conductive plate 62u function to connect the U-phase upper arm freewheeling diode 53u to the U-phase upper arm switching element 51u in an inverse-parallel manner.

Here, both of the projections 81u and 82u are arranged not to overlap the U-phase upper arm gate electrode 51gu. Accordingly, as illustrated in Fig. 7, a U-phase terminal region A, which is a gap corresponding to the projecting dimensions of both of the projections 81u and 82u, is formed between the U-phase upper arm gate electrode 51gu and the U-phase second lower conductive plate surface 62au.

As illustrated in Figs. 7 and 8, the U-phase upper arm control terminal 73u is joined with both of the U-phase upper arm gate electrode 51gu and the U-phase upper arm control pad 71u in a state in which part of the U-phase upper arm control terminal 73u is located in the U-phase terminal region A. The U-phase upper arm control pad 71u is arranged at a position spaced apart from the U-phase upper arm gate electrode 51gu in the Y direction. As illustrated in Figs. 5 and 8, the U-phase upper arm control terminal 73u is shaped to extend in the Y direction as viewed in the Z direction and has the form of a reversed U as viewed from the X direction. The U-phase upper arm control terminal 73u includes a terminal base portion 73au that extends in the Y direction, a terminal base end 73bu that downwardly extends from one end of the terminal base portion 73au and is joined with the U-phase upper arm control pad 71u, and a terminal distal end 73cu that downwardly extends from the other end that is opposite to the one end and is joined with the U-phase upper arm gate electrode 51gu. The terminal distal end 73cu has a length set to be shorter than the projecting dimensions of both of the projections 81u and 82u. As illustrated in Fig. 7, the entire terminal distal end 73cu and part of the terminal base portion 73au are located in the U-phase terminal region A. Part of the U-phase upper arm control terminal 73u projects from both of the U-phase switching elements 51u and 52u in the Y direction as viewed in the Z direction and does not project in the X direction.

As illustrated in Figs. 5 and 8, the U-phase lower arm switching element 52u and the U-phase lower arm freewheeling diode 54u are placed on the U-phase second upper conductive plate surface 62bu. The U-phase second upper conductive plate surface 62bu is formed to be wider than the U-phase lower arm collector electrode 52cu (i.e., U-phase lower arm element lower surface 52au) and joined with (i.e., in contact with) the entire U-phase lower arm collector electrode 52cu through the joining material J. That is, the U-phase second upper conductive plate surface 62bu covers the entire U-phase lower arm element lower surface 52au.

The U-phase lower arm cathode electrode 54cu is joined with the U-phase second upper conductive plate surface 62bu through the joining material J. Thus, the U-phase lower arm cathode electrode 54cu and the U-phase lower arm collector electrode 52cu are electrically connected to each other by the U-phase second conductive plate 62u.

Here, in the present embodiment, the U-phase lower arm switching element 52u and the U-phase upper arm switching element 51u are laminated so that the entire U-phase lower arm switching element 52u and the entire U-phase upper arm switching element 51u overlap each other as viewed in the Z direction. Specifically, the U-phase lower arm switching element 52u and the U-phase upper arm switching element 51u are laminated in a state in which a peripheral edge 52xu of the U-phase lower arm switching element 52u and a peripheral edge 51xu of the U-phase upper arm switching element 51u are aligned in the Z direction. In the same manner, the U-phase lower arm freewheeling diode 54u and the U-phase upper arm freewheeling diode 53u are laminated in a state in which peripheral edges thereof are aligned in the Z direction.

Furthermore, the V-phase second conductive plate 62v and the W-phase second conductive plate 62w have the same shape as the U-phase second conductive plate 62u. In addition, the lamination structure of the upper and lower arms of the V-phase and the W-phase is the same as the lamination structure of the upper and lower arms of the U-phase.

As illustrated in Figs. 5 and 6, the V-phase second conductive plate 62v includes a V-phase second upper conductive plate surface 62bv, on which the V-phase lower arm switching element 52v and the V-phase lower arm freewheeling diode 54v are placed, and a V-phase second lower conductive plate surface 62av that is opposite to the V-phase second upper conductive plate surface 62bv and faces the V-phase upper arm element upper surface 51bv. A V-phase lower arm collector electrode 52cv and a V-phase lower arm cathode electrode 54cv are joined with the V-phase second upper conductive plate surface 62bv. A V-phase first projection 81v and a V-phase second projection 82v, which project from the V-phase second lower conductive plate surface 62av toward the V-phase upper arm element upper surface 51bv and are arranged at positions that do not overlap a V-phase upper arm gate electrode 51gv, are provided on the V-phase second lower conductive plate surface 62av. The V-phase first projection 81v and a V-phase upper arm emitter electrode 51ev are joined with each other, and the V-phase second projection 82v and a V-phase upper arm anode electrode 53av are joined with each other. In addition, the V-phase upper arm control terminal 73v is joined with the V-phase upper arm gate electrode 51gv in a state in which part of the V-phase upper arm control terminal 73v is located between the V-phase upper arm gate electrode 51gv and the V-phase second lower conductive plate surface 62av.

In the same manner, the W-phase second conductive plate 62w includes a W-phase second upper conductive plate surface 62bw, on which the W-phase lower arm switching element 52w and the W-phase lower arm freewheeling diode 54w are placed, and a W-phase second lower conductive plate surface 62aw that is opposite to the W-phase second upper conductive plate surface 62bw and faces the W-phase upper arm element upper surface 51bw. The W-phase lower arm collector electrode 52cw and the W-phase lower arm cathode electrode 54cw are joined with the W-phase second upper conductive plate surface 62bw. The W-phase first projection 81w and the W-phase second projection 82w, which project from the W-phase second lower conductive plate surface 62aw toward the W-phase upper arm element upper surface 51bw and are arranged at positions that do not overlap a W-phase upper arm gate electrode 51gw, are provided on the W-phase second lower conductive plate surface 62aw. The W-phase first projection 81w and the W-phase upper arm emitter electrode 51ew are joined with each other, and the W-phase second projection 82w and a W-phase upper arm anode electrode 53aw are joined with each other. In addition, the W-phase upper arm control terminal 73w is joined with the W-phase upper arm gate electrode 51gw in a state in which part of the W-phase upper arm control terminal 73w is located between the W-phase upper arm gate electrode 51gw and the W-phase second lower conductive plate surface 62aw. Furthermore, the first projections 81u to 81w each correspond to a "first switching element projection."

The third conductive plate 63 is joined with the lower arm emitter electrodes 52eu to 52ew and the lower arm anode electrodes 54au to 54aw. As illustrated in Figs. 5 and 6, the third conductive plate 63 includes a U-phase conductive part 63u that is arranged on an upper side of the U-phase second conductive plate 62u, a V-phase conductive part 63v that is arranged on an upper side of the V-phase second conductive plate 62v, a W-phase conductive part 63w that is arranged on an upper side of the W-phase second conductive plate 62w, and the second input terminal 43b that projects from the U-phase conductive part 63u in the X direction.

The conductive parts 63u to 63w have the same shape. The conductive parts 63u to 63w, which are each T-shaped as viewed in the Z direction, respectively include first extension portions 63au to 63aw, which extend in the X direction, and second extension portions 63bu to 63bw, which extend from the first extension portions 63au to 63aw in the Y direction. The first extension portions 63au to 63aw are connected to each other. That is, the conductive parts 63u to 63w are connected to each other in a state laid out in the X direction. The third conductive plate 63 extends in the X direction as a whole.

Lamination structures of the conductive parts 63u to 63w and the lower arm switching elements 52u to 52w are basically the same. Thus, only the U-phase will now be described in detail.

The U-phase conductive part 63u is laid out so that the U-phase first extension portion 63au overlaps the U-phase lower arm freewheeling diode 54u and the U-phase second extension portion 63bu overlaps the U-phase lower arm switching element 52u as viewed in the Z direction.

As illustrated in Fig. 7, the U-phase lower arm gate electrode 52gu and the U-phase upper arm gate electrode 51gu are provided at positions offset from each other as viewed in the Z direction. Specifically, both of the gate electrodes 51gu and 52gu of the U-phase are arranged to be spaced apart from each other in the X-direction as viewed in the Z direction. In the present embodiment, the positional relationship between the U-phase upper arm gate electrode 51gu and the U-phase upper arm emitter electrode 51eu on the U-phase upper arm element upper surface 51bu is set to be reversed from the positional relationship between the U-phase lower arm gate electrode 52gu and the U-phase lower arm emitter electrode 52eu on the U-phase lower arm element lower surface 52au.

The U-phase second extension portion 63bu covers the U-phase lower arm emitter electrode 52eu so as not to overlap the U-phase lower arm gate electrode 52gu as viewed in the Z direction. Accordingly, the U-phase lower arm gate electrode 52gu is open to an upper side.

As illustrated in Figs. 6 and 7, the U-phase conductive part 63u includes a U-phase third lower conductive plate surface 63cu that faces the U-phase lower arm element upper surface 52bu. A U-phase third projection 83u and a U-phase fourth projection 84u, which project from the U-phase third lower conductive plate surface 63cu toward the U-phase lower arm element upper surface 52bu, are provided on the U-phase third lower conductive plate surface 63cu. In the present embodiment, the U-phase third projection 83u and the U-phase fourth projection 84u are formed from the same material as the U-phase conductive part 63u and integrally with the U-phase conductive part 63u. Accordingly, the projections 83u and 84u are electrically connected to the U-phase conductive part 63u.

The U-phase third projection 83u is provided at a position that overlaps the U-phase lower arm emitter electrode 52eu as viewed in the Z direction. Specifically, the U-phase third projection 83u projects toward a lower side from a portion corresponding to a distal end of the U-phase second extension portion 63bu in the U-phase third lower conductive plate surface 63cu. The U-phase third projection 83u is shaped to be located in a projection range of the U-phase lower arm emitter electrode 52eu as viewed in the Z direction. Specifically, the U-phase third projection 83u has the same shape as the U-phase lower arm emitter electrode 52eu as viewed in the Z direction. As illustrated in Figs. 7 and 8, the U-phase third projection 83u is joined with the U-phase lower arm emitter electrode 52eu by the joining material J. In this case, the U-phase third projection 83u is in contact with the entire U-phase lower arm emitter electrode 52eu through the joining material J.

As illustrated in Figs. 6 and 8, the U-phase fourth projection 84u is provided at a position that overlaps the U-phase lower arm anode electrode 54au as viewed in the Z direction. Specifically, the U-phase fourth projection 84u projects to a lower side from a portion corresponding to the U-phase first extension portion 63au in the U-phase third lower conductive plate surface 63cu. The U-phase fourth projection 84u is shaped to be located in a projection range of the U-phase lower arm anode electrode 54au as viewed in the Z direction. Specifically, the U-phase fourth projection 84u has the same shape as the U-phase lower arm anode electrode 54au as viewed in the Z direction. As illustrated in Fig. 8, the U-phase fourth projection 84u is joined with the entire U-phase lower arm anode electrode 54au by the joining material J. Thus, the U-phase lower arm anode electrode 54au and the U-phase lower arm emitter electrode 52eu are electrically connected to each other by the U-phase conductive part 63u. That is, the U-phase second conductive plate 62u and the U-phase conductive part 63u function to connect the U-phase lower arm freewheeling diode 54u to the U-phase lower arm switching element 52u in inverse-parallel.

In addition, the U-phase third projection 83u and the U-phase fourth projection 84u are set to have the same projecting dimension. There is no limit to the projecting dimension as long as insulation can be ensured between the U-phase third lower conductive plate surface 63cu and the U-phase lower arm element upper surface 52bu.

Both of the two control pads 71u and 72u of the U-phase are arranged at positions spaced apart from the U-phase unit 64u in the Y direction. The U-phase lower arm control pad 72u and the U-phase upper arm control pad 71u are arranged to be spaced apart from each other in the X direction so as not to interfere with each other. The U-phase lower arm control pad 72u is arranged at a position spaced apart from the U-phase lower arm gate electrode 52gu in the Y direction as viewed in the Z direction. The U-phase lower arm control terminal 74u is joined with both of the U-phase lower arm control pad 72u and the U-phase lower arm gate electrode 52gu by the joining material J.

Furthermore, the U-phase lower arm control terminal 74u has the same structure as that of the U-phase upper arm control terminal 73u except in that a terminal base end is longer in length than the terminal base end 73bu of the U-phase upper arm control terminal 73u. That is, the U-phase lower arm control terminal 74u extends in the Y direction as viewed in the Z direction and has the form of a reversed U as viewed from the X direction.

In addition, as illustrated in Fig. 4, both of the control terminals 73u and 74u of the U-phase are provided at positions offset from each other as viewed in the Z direction.

Specifically, both of the gate electrodes 51gu and 52gu of the U-phase are arranged to be spaced apart from each other in the X-direction, and both of the control pads 71u and 72u of the U-phase are arranged to be spaced apart from each other in the X direction. Accordingly, both of the control terminals 73u and 74u of the U-phase, which electrically connect the gate electrode 51gu and 52gu and the control pads 71u and 72u, are arranged to be spaced apart from each other in the X direction without interfering each other.

The V-phase unit 64v and the W-phase unit 64w are constructed in the same manner as the U-phase unit 64u. Specifically, the V-phase conductive part 63v includes a V-phase third lower conductive plate surface 63cv that faces the V-phase lower arm element upper surface 52bv. A V-phase third projection 83v and a V-phase fourth projection 84v, which project from the V-phase third lower conductive plate surface 63cv toward the V-phase lower arm element upper surface 52bv, are provided on the V-phase third lower conductive plate surface 63cv. The V-phase third projection 83v and the V-phase lower arm emitter electrode 52ev are joined with each other, and the V-phase fourth projection 84v and the V-phase lower arm anode electrode 54av are joined with each other. Both of the gate electrodes 51gv and 52gv of the V-phase are provided at positions offset from each other as viewed in the Z direction, and the control terminals 73v and 74v of the V-phase are arranged at positions offset from each other as viewed in the Z direction.

In the same manner, the W-phase conductive part 63w includes a W-phase third lower conductive plate surface 63cw that faces the W-phase lower arm element upper surface 52bw. A W-phase third projection 83w and a W-phase fourth projection 84w, which project from the W-phase third lower conductive plate surface 63cw toward the W-phase lower arm element upper surface 52bw, are provided on the W-phase third lower conductive plate surface 63cw. The W-phase third projection 83w and the W-phase lower arm emitter electrode 52ew are joined with each other, and the W-phase fourth projection 84w and the W-phase lower arm anode electrode 54aw are joined with each other. Both of the gate electrodes 51gw and 52gw of the W-phase are provided at positions offset from each other as viewed in the Z direction, and the control terminals 73w and 74w of the W-phase are arranged at positions offset from each other as viewed in the Z direction. The third projections 83u to 83w each correspond to a "second switching element projection."

The lower arm emitter electrodes 52eu to 52ew are electrically connected to one another by the third conductive plate 63. That is, the third conductive plate 63 functions to electrically connect the same phases of the lower arm emitter electrodes 52eu to 52ew and the lower arm anode electrodes 54au to 54aw. The third conductive plate 63 also functions to electrically connect the lower arm emitter electrodes 52eu to 52ew of units 64u to 64w to one another.

Furthermore, although not illustrated in the drawings, the units 64u to 64w are actually sealed in a hermetic manner by an insulating resin. Accordingly, a gap portion of the U-phase terminal region A and the like is filled with the resin. In addition, in the present embodiment, the projecting direction of the output terminals 43u to 43w intersects (specifically, perpendicular to) the projecting direction of both of the input terminals 43a and 43b

The operation of the present embodiment will now be described.

The first projections 81u to 81w are joined with the upper arm emitter electrodes 51eu to 51ew, the upper arm emitter electrodes 51eu to 51ew and the lower arm collector electrodes 52cu to 52cw are electrically connected to each other by the second conductive plates 62u to 62w. The first projections 81u to 81w are provided at positions that do not overlap the upper arm gate electrodes 51gu to 51gw. Thus, the upper arm control terminals 73u to 73w may be located between the upper arm gate electrodes 51gu to 51gw and the second lower conductive plate surfaces 62au to 62aw. In addition, parts of the upper arm control terminals 73u to 73w are located between the upper arm gate electrodes 51gu to 51gw and the second lower conductive plate surfaces 62au to 62aw. This avoids interference between the upper arm control terminals 73u to 73w and the second conductive plates 62u to 62w.

The present embodiment has the advantages described below.
(1) The inverter module 43 includes upper arm switching elements 51u to 51w, which are placed on the first conductive plate 61, and the lower arm switching elements 52u to 52w, which are laminated on the upper arm switching elements 51u to 51w with the second conductive plates 62u to 62w located in between. The switching elements 51u to 52w are formed from silicon carbide. This configuration allows for reduction in the mounting area of the switching elements 51u to 52w, specifically, the area occupied by the switching elements 51u to 52w in a plane perpendicular to the lamination direction (Z direction) of the switching elements 51u to 51w and the switching elements 52u to 52w. That is, the mounting area can be reduced in comparison to a configuration in which the upper arm switching elements 51u to 51w and the lower arm switching elements 52u to 52w are arranged next to one another on the first conductive plate 61. This allows the inverter module 43 to be reduced in size.
   In a structure in which the lower arm switching elements 52u to 52w are laminated on the upper arm switching elements 51u to 51w, heat has a tendency to accumulate in the switching elements 51u to 52w. In this regard, in the present embodiment, the switching elements 51u to 52w are formed from silicon carbide. A switching element that uses silicon carbide generates less heat and has superior heat resistance as compared with a switching element formed from silicon. Thus, it is possible to cope with the shortcoming that occurs when the lower arm switching elements 52u to 52w are laminated on the upper arm switching elements 51u to 51w.
   In addition, in a switching element formed from silicon carbide, the on-resistance has a tendency to decrease. Thus, even when the switching elements 51u to 52w have a small size, the desired on-resistance can be obtained. This allows the switching elements 51u to 52w to be reduced in size while obtaining the desired on-resistance. Thus, the inverter module 43 may be reduced in size.
(2) The upper arm switching elements 51u to 51w respectively include the upper arm element upper surfaces 51bu to 51bw. The upper arm emitter electrodes 51eu to 51ew and the upper arm gate electrodes 51gu to 51gw, to which the upper arm control terminals 73u to 73w are joined, are formed on the upper arm element upper surfaces 51bu to 51bw. The upper arm switching elements 51u to 51w respectively include the upper arm element lower surfaces 51au to 51aw, which are opposite to the upper arm element upper surfaces 51bu to 51bw. The upper arm collector electrodes 51cu to 51cw joined with the first conductive plate 61 are formed on the upper arm switching elements 51u to 51w. The lower arm switching elements 52u to 52w respectively include the lower arm element upper surfaces 52bu to 52bw, on which the lower arm emitter electrodes 52eu to 52ew and the lower arm gate electrodes 52gu to 52gw are formed. The lower arm emitter electrodes 52eu to 52ew are joined with the third conductive plate 63 provided on the lower arm switching elements 52u to 52w. The lower arm gate electrodes 52gu to 52gw are joined with the lower arm control terminals 74u to 74w. The lower arm switching elements 52u to 52w respectively include the lower arm element lower surfaces 52au to 52aw, which are opposite to the lower arm element upper surfaces 52bu to 52bw. The lower arm collector electrodes 52cu to 52cw are formed on the lower arm element lower surfaces 52au to 52aw.
   In the above-described configuration, the second conductive plates 62u to 62w respectively include the second upper conductive plate surfaces 62bu to 62bw, on which the lower arm switching elements 52u to 52w are placed, and the second lower conductive plate surfaces 62au to 62aw, which are opposite to the second upper conductive plate surfaces 62bu to 62bw and face the upper arm element upper surfaces 51bu to 51bw in the Z direction. The second upper conductive plate surfaces 62bu to 62bw are respectively joined with the lower arm collector electrodes 52cu to 52cw and entirely cover the lower arm element lower surfaces 52au to 52aw. In addition, the first projections 81u to 81w, which project from the second lower conductive plate surfaces 62au to 62aw toward the upper arm element upper surfaces 51bu to 51bw and are joined with the upper arm emitter electrodes 51eu to 51ew, are respectively provided in the second lower conductive plate surfaces 62au to 62aw. The first projections 81u to 81w are provided at positions that do not overlap the upper arm gate electrodes 51gu to 51gw as viewed in the Z direction. Further, parts of the upper arm control terminals 73u to 73w are located between the upper arm gate electrodes 51gu to 51gw and the second lower conductive plate surfaces 62au to 62aw.
   This configuration realizes the electrical connection of the upper arm emitter electrodes 51eu to 51ew and the lower arm collector electrodes 52cu to 52cw with the second conductive plates 62u to 62w. Further, the electrical connection of the upper arm control terminals 73u to 73w and the upper arm gate electrodes 51gu to 51gw can be realized without interference with the second conductive plates 62u to 62w.
   In addition, the present embodiment increases heat dissipation of the inverter module 43. Specifically, to realize the electrical connection described above under a situation in which the upper arm emitter electrodes 51eu to 51ew and the upper arm gate electrodes 51gu to 51gw exist on the upper arm element upper surfaces 51bu to 51bw, for example, the portions corresponding to the upper arm gate electrodes 51gu to 51gw in the second conductive plates 62u to 62w can be cutaway. In this case, the lower arm element lower surfaces 52au to 52aw will include sections that are not covered by the second conductive plates 62u to 62w. Such sections limit the transfer of heat to the second conductive plates 62u to 62w and hinder heat dissipation. In this manner, heat dissipation deteriorates when realizing electrical connection between the upper arm gate electrodes 51gu to 51gw and the upper arm control terminals 73u to 73w. Thus, the lower arm element lower surfaces 52au to 52aw may include sections where the temperature locally rises and deteriorates the heat resistance.
   Particularly, the first conductive plate 61 is mounted on to the insulation substrate 60 that allows for heat exchange with the refrigerant through the inverter case 31 and the housing 11. This facilitates cooling of the upper arm switching elements 51u to 51w that are placed on the first conductive plate 61. In contrast, it is difficult to cool the lower arm switching elements 52u to 52w, which are laminated on the upper arm switching elements 51u to 51w with the second conductive plates 62u to 62w located in between. Thus, the temperature easily rises when the lower arm element lower surfaces 52au to 52aw of the lower arm switching elements 52u to 52w includes sections that are not covered by the second conductive plates 62u to 62w.
   In the present embodiment, the second upper conductive plate surfaces 62bu to 62bw cover the entire lower arm element lower surfaces 52au to 52aw. This avoids the formation of sections where heat has a tendency to accumulate. In addition, parts of the upper arm control terminals 73u to 73w are located between the upper arm gate electrodes 51gu to 51gw and the second lower conductive plate surfaces 62au to 62aw. This allows for electrical connection between the upper arm control terminals 73u to 73w and the upper arm gate electrodes 51gu to 51gw to be realized without interfering with the second conductive plates 62u to 62w while covering the entire lower arm element lower surfaces 52au to 52aw with the second conductive plates 62u to 62w. This resolves the shortcoming described above.
(3) The lower arm collector electrodes 52cu to 52cw are formed by the entire lower arm element lower surfaces 52au to 52aw, and the second upper conductive plate surfaces 62bu to 62bw are in contact with the entire lower arm collector electrodes 52cu to 52cw. This configuration lowers the on-resistance.
   Specifically, for example, when notches are formed in the second conductive plates 62u to 62w as described above, even when the lower arm collector electrodes 52cu to 52cw are formed by the entire lower arm element lower surfaces 52au to 52aw, parts of the lower arm collector electrodes 52cu to 52cw do not contact the second conductive plates 62u to 62w. Thus, parts of the lower arm collector electrodes 52cu to 52cw do not function. This increases the on-resistance. In this regard, the present configuration includes the first projections 81u to 81w. This avoids interference between the upper arm control terminals 73u to 73w and the second conductive plates 62u to 62w and electrically connects the upper arm control terminals 73u to 73w to the upper arm gate electrodes 51gu to 51gw while the lower arm collector electrodes 52cu to 52cw entirely contact the second upper conductive plate surfaces 62bu to 62bw. This resolves the shortcoming described above.
(4) The upper arm gate electrodes 51gu to 51gw are arranged at positions offset from the lower arm gate electrodes 52gu to 52gw as viewed in the Z direction, and the upper arm control terminals 73u to 73w are arranged at positions offset from the lower arm control terminals 74u to 74w as viewed in the Z direction. With this configuration, the upper arm gate electrodes 51gu to 51gw are arranged at positions offset from the lower arm gate electrodes 52gu to 52gw as viewed in the Z direction. This easily avoids interference between the upper arm control terminals 73u to 73w and the lower arm control terminals 74u to 74w.
(5) The U-phase upper arm switching element 51u and the U-phase lower arm switching element 52u are laminated in a state in which the peripheral edge 51xu of the U-phase upper arm switching element 51u and the peripheral edge 52xu of the U-phase lower arm switching element 52u are aligned in the Z direction. With this configuration, the mounting area of both of the U-phase switching elements 51u and 52u can be reduced in comparison with a configuration in which both of the U-phase switching elements 51u and 52u are laminated in a state offset from each other as viewed in the Z direction. Thus, the inverter module 43 may be further reduced in size. The same applies to the other phases.
(6) The third conductive plate 63 includes the conductive parts 63u to 63w that respectively correspond to the U-phase, the V-phase, and the W-phase. The conductive parts 63u to 63w respectively include the third lower conductive plate surfaces 63cu to 63cw that face the lower arm element upper surfaces 52bu to 52bw. The third projections 83u to 83w, which project from the third lower conductive plate surfaces 63cu to 63cw toward the lower arm element upper surfaces 52bu to 52bw and are joined with the lower arm emitter electrodes 52eu to 52ew, are respectively provided on the third lower conductive plate surfaces 63cu to 63cw. With this configuration, the third lower conductive plate surfaces 63cu to 63cw and the lower arm element upper surfaces 52bu to 52bw can be arranged spaced apart from one another. This avoids unintentional contact and improves insulation.
(7) The units 64u to 64w respectively include the upper arm switching elements 51u to 51w, the lower arm switching elements 52u to 52w, the upper arm control terminals 73u to 73w, the lower arm control terminals 74u to 74w, and the second conductive plates 62u to 62w. The units 64u to 64w are laid out on the first conductive plate 61 in one direction (specifically, the X direction). This configuration decreases the mounting area per unit and allows the units 64u to 64w to be entirely reduced in size.
   Particularly, when laying out the units 64u to 64w, it is preferable that the intervals between the units 64u to 64w be increased from the viewpoint of heat dissipation. However, a longer interval will enlarge the inverter module 43. In contrast, in the present embodiment, as described above, the improvement of heat dissipation in each of the units 64u to 64w allows the intervals to be shortened. This allows the inverter module 43 to be further reduced in size.
(8) The inverter module 43 includes the insulation substrate 60, on which the first conductive plate 61 is attached. The insulation substrate 60 includes the upper arm control pads 71u to 71w, with which the upper arm control terminals 73u to 73w are joined, and the lower arm control pads 72u to 72w, with which the lower arm control terminals 74u to 74w are joined. With this configuration, the controller 44, which controls the switching elements 51u to 52w, is electrically connected to the gate electrodes 51gu to 52gw.
(9) Both of the control pads 71u and 72u of the U-phase are arranged at positions spaced apart from the U-phase unit 64u in the Y direction that is a direction perpendicular to the layout direction of the units 64u to 64w. In addition, both of the control terminals 73u and 74u of the U-phase extend in the Y direction as viewed in the Z direction. This also applies to the other phases. With this configuration, both of the control pads 71u and 72u of the U-phase and both of the control terminals 73u and 74u of the U-phase do not interferes with the arrangement of the units 64u to 64w. Specifically, to avoid interference of the V-phase unit 64v, which is adjacent to the U-phase unit 64u, with both of the control pads 71u and 72u, for example, there is no need to widen the interval between the U-phase unit 64u and the V-phase unit 64v. This allows the interval of the units 64u to 64w to be decreased.
(10) The units 64u to 64w respectively include the upper arm freewheeling diodes 53u to 53w and the lower arm freewheeling diodes 54u to 54w. In addition, the first conductive plate 61 and the second conductive plates 62u to 62w connect the upper arm freewheeling diodes 53u to 53w to the upper arm switching elements 51u to 51w in inverse-parallel, and the second conductive plates 62u to 62w and the third conductive plate 63 connect the lower arm freewheeling diodes 54u to 54w to the lower arm switching elements 52u to 52w in inverse-parallel. With this configuration, the first conductive plate 61, the second conductive plates 62u to 62w, and the third conductive plate 63 are also used for electrical connection between the freewheeling diodes 53u to 54w and the switching elements 51u to 52w. This simplifies the configuration. In addition, the freewheeling diodes 53u to 54w are combined with the switching elements 51u to 52w as units. This allows for further reduction in the size of the inverter module 43.
(11) The inverter device 30 includes the inverter module 43, the transformer 41 that transforms DC power supplied from the DC power supply E, and the filter circuit 42 that receives the DC power transformed by the transformer 41. The inverter module 43 converts the DC power output from the filter circuit 42 into AC power for driving the electric motor 13. This drives the electric motor 13.

The switching elements 51u to 52w are formed from silicon carbide and have a small switching loss. This allows the inverter module 43 to operate at high frequencies. For example, when the controller 44 performs pulse width modulation (PWM) control on the inverter module 43, a high carrier frequency can be set. This allows the cut-off frequency of the filter circuit 42 to be raised. The filter circuit 42 removes noise from the inverter module 43. Accordingly, the inductance of the filter coil 42a and the capacitance of the filter capacitor 42b may be lowered. The filter coil 42a and the filter capacitor 42b are elements of the filter circuit 42. Thus, the filter circuit 42 may be reduced in size. This, in turn, allows the entire inverter device 30 to be reduced in size.

The above-described embodiment may be modified as follows.

The switching elements 51u to 52w are not limited to IGBTs and may be MOSFETs formed from silicon carbide (SiC), and the like. For example, when the switching elements 51u to 52w are n-type MOSFETs, the switching elements 51u to 52w include a source electrode instead of the emitter electrodes 51eu to 52ew and a drain electrode instead of the collector electrodes 51cu to 52cw. That is, the upper arm switching elements 51u to 51w each include an upper arm drain electrode as a first lower electrode and an upper arm source electrode as a first upper electrode. The lower arm switching elements 52u to 52w each include a lower arm drain electrode as a second lower electrode and a lower arm source electrode as a second upper electrode.

Furthermore, when MOSFETs are employed as the switching elements 51u to 52w, a parasitic diode of the MOSFET functions as the freewheeling diodes 53u to 54w. Thus, the freewheeling diodes 53u to 54w may be omitted. That is, the freewheeling diodes 53u to 54w are not essential.

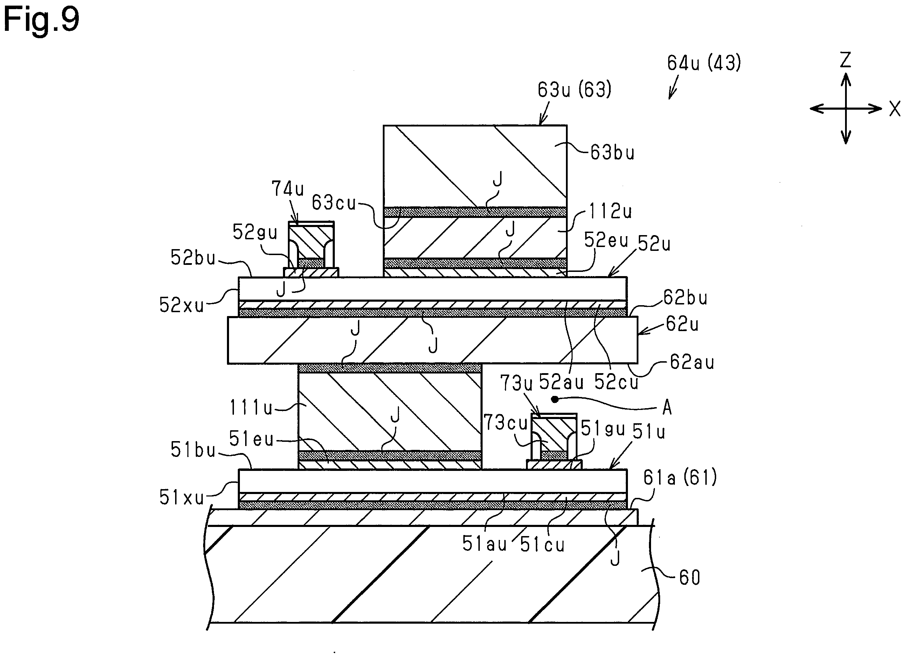

As illustrated in Fig. 9, a U-phase first projection 111u may be configured separately from the U-phase second conductive plate 62u. In this case, for example, the U-phase first projection 111u may be formed from a conductive material such as copper and molybdenum, and the U-phase first projection 111u and the U-phase second conductive plate 62u may be joined with each other by the joining material J. In this case, the U-phase first projection 111u functions as a heat mass. In the same manner, a U-phase third projection 112u and the U-phase second extension portion 63bu may be provided separately from each other and be joined with each other by the joining material J.

The upper arm switching elements 51u to 51w may be laminated on the lower arm switching elements 52u to 52w. That is, the "first switching element" may be an upper arm switching element or a lower arm switching element. This also applies to the "second switching element."

The inverter module 43 includes three units 64u and 64w. However, there may be any number of units. For example, only one unit may be provided.

The inverter module 43 can be used to drive the electric motor 13 of the motor-driven compressor 10 that is installed in a vehicle. However, there is no limit to the application of the inverter module 43. For example, when a vehicle-driving motor is installed in a vehicle, the inverter module 43 may be used to drive the vehicle-driving motor.

The semiconductor module is not limited to the inverter module 43. For example, the semiconductor module may be a DC/DC converter module or a charger module.

The U-phase first projection 81u has the same shape as the U-phase upper arm emitter electrode 51eu as viewed in the Z direction but there is no limit to the shape. The U-phase first projection 81u may have any shape as long as it does not project out of the U-phase upper arm emitter electrode 51eu as viewed in the Z direction. In addition, the U-phase first projection 81u may slightly project from the U-phase upper arm emitter electrode 51eu as viewed in the Z direction as long as it does not interfere with the U-phase upper arm control terminal 73u. However, it is preferable that the U-phase first projection 81u be in a projection range of the U-phase upper arm emitter electrode 51eu as viewed in the Z direction from the viewpoint of insulation properties.

The emitter electrodes 51eu to 52ew, the collector electrodes 51cu to 52cw, and the gate electrodes 51gu to 52gw may have any shape or be located at any position. For example, the upper arm gate electrodes 51gu to 51gw and the lower arm gate electrodes 52gu to 52gw may overlap each other as viewed in the Z direction. In addition, the collector electrodes 51cu to 52cw may be formed in parts of the element lower surfaces 51au to 52aw.

The control pads 71u to 72w may be located at any position or have any shape as long as the control terminals 73u to 74w can be arranged without interfering each other.

Part of the U-phase upper arm control terminal 73u and part of the U-phase lower arm control terminal 74u may overlap each other in the Z direction in a state in which a height difference exists. This also applies to the other phases.

The third conductive plate 63 may have any shape. For example, the third projections 83u to 83w or the fourth projections 84u to 84w may be omitted.

The U-phase upper arm switching element 51u and the U-phase lower arm switching element 52u may be laminated in a state offset from each other as viewed in the Z direction. In other words, a non-overlapping region may exist between the U-phase upper arm switching element 51u and the U-phase lower arm switching element 52u. However, it is preferable that both of the U-phase switching elements 51u and 52u be laminated in a state in which the peripheral edge 51xu of the U-phase upper arm switching element 51u and the peripheral edge 52xu of the U-phase lower arm switching element 52u are aligned to decrease the mounting area.

The semiconductor module may be configured as follows. That is, the semiconductor module includes a first conductive plate, a switching element placed on the first conductive plate and formed from silicon carbide, a second conductive plate arranged on the switching element, an SiC element that is laminated on the second conductive plate and formed from silicon carbide, and a control terminal. The switching element includes a first element upper surface on which a first upper electrode and a gate electrode that is joined with the control terminal is formed, and a first element lower surface located at a side opposite to the first element upper surface and on which a first lower electrode joined with the first conductive plate is formed. The SiC element includes a second element upper surface, on which a second upper electrode is formed, and a second element lower surface, which is located at a side opposite to the second element upper surface and on which a second lower electrode is formed. The second conductive plate includes a second upper conductive plate surface, on which the SiC element is placed and which is joined with the second lower electrode covering the entire second element lower surface, and a second lower conductive plate surface, which is located at a side opposite to the second upper conductive plate surface facing the first element upper surface. A projection is arranged on the second lower conductive plate surface projecting from the second lower conductive plate surface toward the first element upper surface and joined with the first upper electrode, and the projection is arranged at a position that does not overlap the gate electrode when viewed from a lamination direction of the switching element and the SiC element. Part of the control terminal is located between the gate electrode and the second lower conductive plate surface.

As described above, a SiC element other than the switching element may be laminated on the switching element with the second conductive plate located in between. As the SiC element other than the switching element, for example, a diode that is formed from silicon carbide or the like may be used. In this case, one of an anode electrode and a cathode electrode corresponds to the second upper electrode, and the other one corresponds to the second lower electrode. In addition, as the switching element, an emitter electrode may be formed on the element lower surface and a collector electrode may be formed on the element upper surface.

## Claims

1. A semiconductor module comprising:
a first conductive plate;
a first switching element that is placed on the first conductive plate and formed from silicon carbide;
a second conductive plate arranged on the first switching element;
a second switching element laminated on the second conductive plate and formed from silicon carbide;
a third conductive plate arranged on the second switching element; and
first and second control terminals,
wherein the first switching element includes
a first element upper surface on which a first upper electrode and a first gate electrode with which the first control terminal is joined are formed, and
a first element lower surface located at a side opposite to the first element upper surface and on which a first lower electrode joined with the first conductive plate is formed,
the second switching element includes
a second element upper surface on which a second upper electrode joined with the third conductive plate and a second gate electrode with which the second control terminal is joined are formed, and
a second element lower surface located at a side opposite to the second element upper surface, wherein a second lower electrode is formed on the second element lower surface,
the second conductive plate includes
a second upper conductive plate surface on which the second switching element is placed and which is joined with the second lower electrode and covers the entire second element lower surface, and
a second lower conductive plate surface located at a side opposite to the second upper conductive plate surface and facing the first element upper surface,
the second lower conductive plate surface includes a projection projecting from the second lower conductive plate surface toward the first element upper surface and joined with the first upper electrode,
the projection is located at a position that does not overlap the first gate electrode as viewed in a lamination direction of the first and second switching elements, and
part of the first control terminal is located between the first gate electrode and the second lower conductive plate surface.

2. The semiconductor module according to claim 1, wherein
the second lower electrode is formed on the entire second element lower surface, and
the second upper conductive plate surface is in contact with the entire second lower electrode.

3. The semiconductor module according to claim 1 or 2, wherein
the first gate electrode and the second gate electrode are located at positions offset from each other as viewed in the lamination direction, and
the first control terminal and the second control terminal are located at positions offset from each other as viewed in the lamination direction.

4. The semiconductor module according to any one of claims 1 to 3, wherein the first switching element and the second switching element are laminated in a state in which a peripheral edge of the first switching element and a peripheral edge of the second switching element are aligned in the lamination direction.

5. The semiconductor module according to any one of claims 1 to 4, wherein the third conductive plate includes a third lower conductive plate surface facing the second element upper surface, and
the third lower conductive plate surface includes a projection that projects from the third lower conductive plate surface toward the second element upper surface and is joined with the second upper electrode.

6. The semiconductor module according to any one of claims 1 to 5, further comprising:
an insulation substrate on which the first conductive plate is mounted;
a first control pad arranged on the insulation substrate and joined with the first control terminal; and
a second control pad arranged on the insulation substrate and joined with the second control terminal.

7. The semiconductor module according to claim 6, further comprising:
a plurality of units laid out on the first conductive plate in one direction, wherein each of the plurality of units includes the first switching element, the second switching element, the first control terminal, the second control terminal, and the second conductive plate;
wherein the first control pad and the second control pad are arranged at positions spaced apart from a corresponding one of the plurality of units in a direction perpendicular to a layout direction of the plurality of units, and
the first control terminal and the second control terminal extend in a direction perpendicular to the layout direction as viewed in the lamination direction.

8. The semiconductor module according to any one of claims 1 to 7, wherein:
the first switching element is an IGBT that is an upper arm switching element, the first lower electrode is an upper arm collector electrode, and the first upper electrode is an upper arm emitter electrode; and
the second switching element is an IGBT that is a lower arm switching element, the second lower electrode is a lower arm collector electrode, and the second upper electrode is a lower arm emitter electrode.

9. The semiconductor module according to any one of claims 1 to 7, wherein:
the first switching element is an n-type MOSFET that is an upper arm switching element, the first lower electrode is an upper arm drain electrode, and the first upper electrode is an upper arm source electrode; and
the second switching element is an n-type MOSFET that is a lower arm switching element, the second lower electrode is a lower arm drain electrode, and the second upper electrode is a lower arm source electrode.

10. An inverter device including the semiconductor module according to any one of claims 1 to 9 and configured to drive an electric motor that is arranged in a motor-driven compressor for a vehicle, the inverter device comprising:
a transformer that transforms DC power; and
an LC filter circuit to which the DC power transformed by the transformer is input,
wherein the semiconductor module is configured to convert the DC power output from the LC filter circuit into drive power that allows the electric motor to be driven.

11. A semiconductor module comprising:
a first conductive plate;
a switching element that is placed on the first conductive plate and formed from silicon carbide;
a second conductive plate arranged on the switching element;
an SiC element that is laminated on the second conductive plate and formed from silicon carbide; and
a control terminal,
wherein the switching element includes
a first element upper surface on which a first upper electrode and a gate electrode with which the control terminal is joined are formed, and
a first element lower surface located at a side opposite to the first element upper surface and on which a first lower electrode joined with the first conductive plate is formed,
the SiC element includes
a second element upper surface on which a second upper electrode is formed, and
a second element lower surface located at a side opposite to the second element upper surface, wherein a second lower electrode is formed on the second element lower surface,
the second conductive plate includes
a second upper conductive plate surface on which the SiC element is placed and which is joined with the second lower electrode and covers the entire second element lower surface, and
a second lower conductive plate surface located at a side opposite to the second upper conductive plate surface and facing the first element upper surface,
the second lower conductive plate surface includes a projection projecting from the second lower conductive plate surface toward the first element upper surface and joined with the first upper electrode,
the projection is located at a position that does not overlap the gate electrode as viewed from a lamination direction of the switching element and the SiC element, and
part of the control terminal is located between the gate electrode and the second lower conductive plate surface.
